# EUROPÄISCHE PATENTANMELDUNG

(11) **EP 2 224 251 A1**
(43) Veröffentlichungstag der Anmeldung: **01.09.2010**
(21) Anmeldenummer: 10001870.4
(22) Anmeldetag: 24.02.2010
(51) Int. Cl.: G01R 15/14

(54) **Vorrichtung zum Umschalten und Messen von Spannung und Stromstärke an Bord eines Schienenfahrzeuges mit elektrischem Antrieb**

(30) Priorität: 26.02.2009 IT MI20090282
(71) Anmelder: Tem Elettronica S.r.l., 26900 Lodi (IT)
(72) Erfinder: Ardemagni, Pierenrico, 26900 Lodi (IT); Fantini, Maurizio, 26900 Lodi (IT)
(74) Vertreter: Mayer, Hans Benno

(57) **Zusammenfassung**

Vorrichtung zum Umschalten und Messen von Spannung und Stromstärke an Bord eines Schienenfahrzeuges mit elektrischem Antrieb, mit der Möglichkeit, die Antennen und die Übertragungssysteme gegenüber einer niedrigen Spannung an Bord eines Schienenfahrzeuges zu isolieren, unter Vorsehung eines für Wechselstrom oder Gleichstrom ausgelegten Sensors, der an der Oberseite eines aus Isoliermaterial bestehenden Körpers angeordnet ist, der einen vorgeschalteten Spannungsteiler aufweist, zum Messen einer Gleichspannung oder Wechselspannung, wobei vorgesehen ist, dass eine oder mehrere Antennen und Übertragungssysteme des Typs GPS, GSM, GPRS an der Oberseite des Körpers installiert sind, und der Sensor, der Teiler und das Übertragungssystem mit einer elektronischen Karte wirkverbunden sind, die über einen Transformator gespeist wird, wobei die elektronische Karte Signale erarbeitet,und diese Signale über ein oder mehrere optische Kabel einem zweiten Schaltkreis zugeführt werden, der im Fußteil des Isolierkörpers angeordnet ist, und dieser Schaltkreis einer Ausgangsleitung alle Signale zur Verfügung stellt, die für eine Übertragung durch die Antennen dienen, und die relativen Messsignale für den Leitungsstrom, der den Sensor durchläuft, sowie für die Spannung, die zwischen dem Punkt und der Masse ansteht, die den Fuß der gesamten Vorrichtung bildet.

## Beschreibung

"Vorrichtung zum Umschalten und Messen von Spannung und Stromstärke an Bord eines Schienenfahrzeuges mit elektrischem Antrieb"

Die vorstehende Erfindung betrifft eine Vorrichtung mit der doppelten Funktion, Spannung und Stromstärke eines Schienenfahrzeuges zu messen und einen oder mehrere Übertragungskanäle GSM, GPS, GPRS zur Verfügung zu stellen.

Die Vorrichtung findet Anwendung an Bord von Schienenfahrzeugen mit elektrischem Antrieb.

Schienenfahrzeuge werden heute mit einer Leitungsspannung bis zu 25 kV beschickt, somit ist an Bord des Schienenfahrzeuges eine Messung der Hochspannung, sowie des aufgenommenen Stromes erforderlich.

Um diese Messungen unter Zuhilfenahme von herkömmlichen Einrichtungen durchzuführen, werden induktiv arbeitende Messtransformatoren, Transduktoren mit Halleffekt sowie elektronische Transduktoren verwendet.

Die besonderen Merkmale, die von den vorgenannten Transformatoren und Transduktoren erfüllt werden müssen, sind in einer einwandfreien elektrischen Isolierung und einem Schutz gegen atmosphärische Impulse, sowie in der Genauigkeit der Messung zu sehen.

Die elektrische Isolierung gegenüber der Leitung mit bis zu 25 kV ist als Voraussetzung der elektrischen Merkmale anzusehen, da von einer einwandfreien elektrischen Isolierung die Sicherheit der abwärts liegenden Vorrichtung, sowie die Sicherheit für die Personen, die auf dem Schienenfahrzeug tätig werden, gegeben wird.

Die geltenden Europäischen Normen regeln Leistung und

Merkmale, die Vorrichtungen an Bord von Schienenfahrzeugen aufweisen müssen, dies sowohl hinsichtlich der Größen von Prüfspannungen als auch hinsichtlich einer Vorgehensweise, mit denen die Geräte einem Test zu unterziehen sind, der für Leitungsspannungen bis zu 25 kV betrieben wird.

Es ist daher Aufgabe der Erfindung, eine Vorrichtung vorzuschlagen, mit der alle diese Normen zufriedenstellend erfüllt werden.

Diese Aufgabe wird mit einer Vorrichtung zum Messen der Spannung und des Stromes an Bord von Schienenfahrzeugen mit elektrischem Antrieb gelöst, unter Vorsehung mehrerer Übertragungskanäle GPS, GPRS, GSM, die gegenüber der Spannung für den elektrischen Antrieb isoliert sind, wobei ein Körper 3 aus Silikon einen Spannungsteiler 4 und einen Sensor 2 für Wechsel- oder Gleichstrom, sowie einen Transformator 8 aufnimmt, der die Stromkreise 7, die an Hochspannung angelegt sind, gegenüber der Niederspannung isoliert und ferner zwei oder mehrere optische Kabel 9 aufweist, welche für die Verbindung zwischen den Stromkreisen 7, die an Hochspannung angelegt sind und

Stromkreisen 10, die an Niederspannung anliegen, sorgen, wobei ein Stromkreis 7, der an Hochspannung angelegt ist, dazu geeignet ist, die Spannung zwischen einem Punkt 12 und einem Punkt 13 und die Stromstärke zwischen einem Punkt 12 und einem Punkt 14 durch den Sensor 2 zu messen, und eine Verbindung zu einer Übertragungsvorrichtung 6 des Typs GPS, GSM, GPRS zu schaffen, und Messungen und

Daten zu übertragen und zu empfangen, unter Einsatz von optischen Kabeln 9, mittels eines zweiten Schaltkreises 10, der an Masse 13 anliegt und geeignet ist, die in Digitalformat übertragenen Messdaten des Stromkreises 7 auszuwerten und mit den Geräten an Bord des Schienenfahrzeuges über die außenliegenden Verbindungen 11 zu kommunizieren.

In vorteilhafter Weise schlägt die Vorrichtung zum Messen der Spannung sowie der Stromstärke an Bord eines Schienenfahrzeuges mit elektrischem Antrieb vor, dass der aus Silikon bestehende Körper 3 die Form eines elektrischen Isolators aufweist, der einen Stromsensor beinhaltet, mit dem sowohl Gleichstrom als auch Wechselstrom messbar sind.

Ferner sieht die Vorrichtung zum Messen des Stromes an Bord eines Schienenfahrzeuges mit elektrischem Antrieb vor, entsprechend der vorstehenden Erfindung, dass im oberen Teil des aus Silikon bestehenden Körpers 3 eine Übertragungsvorrichtung 6 installierbar und elektrisch verbindbar ist und die Übertragungsvorrichtung 6 elektrisch angeschlossen ist, um die GPS-Signale über die Antennen 5 aufzunehmen und Signale über die Kanäle GSM und GPRS zu empfangen und zu übertragen.

In vorteilhafter Weise sieht die Vorrichtung zum Messen der Spannung sowie des Stromes an Bord eines Schienenfahrzeuges mit elektrischem Antrieb vor, dass die Messung der Spannung und des Stromes über den elektrischen Schaltkreis 7 erfolgt, der elektrisch an Hochspannung der Antriebsleitung angelegt ist.

Schließlich, um die Spannung sowie den Strom an Bord des Schienenfahrzeuges mit elektrischem Antrieb zu messen, wird erfindungsgemäß vorgeschlagen, dass die beiden elektronischen Schaltkreise 7 und 10 untereinander über einen Isoliertransformator 8 und optische Kabel 9 verbunden sind, wobei der erste Schaltkreis 7 zur Messung und zur Übertragung der Daten an die Vorrichtungen 6 dient, sofern dies erwünscht wird, und der zweite Schaltkreis 10 dazu dient, die vom Schaltkreis 7 erhaltenen Messdaten in geeigneter Form umzuwandeln, um von den Vorrichtungen und

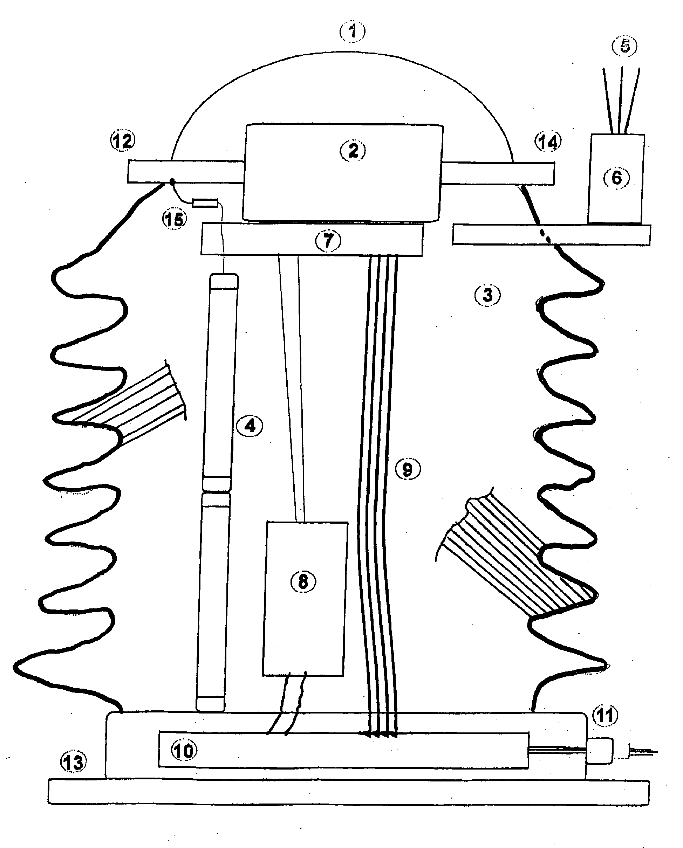

Einrichtungen an Bord des Schienenfahrzeuges verwendet zu werden. Die Messvorrichtung entsprechend der vorstehenden Erfindung, die zum Messen der Spannung und der Stromstärke an Bord eines Schienenfahrzeuges mit elektrischem Antrieb dient, ist in der beigefügten Zeichnung dargestellt.

Die Vorrichtung zum Messen von Spannung und Stromstärke besteht erfindungsgemäß aus einem Körper in isolierendem Material, z.B. Silikon, der in seinem Inneren einen Transformator aufnimmt und derartig ausgebildet ist, dass eine erforderliche Isolierung zwischen der Hochspannung und der Masse des Fahrzeuges gewährleistet ist.

Der genannte Körper nimmt ferner eine oder mehrere Leitungen aus optischen Fasern, sowie einen Spannungsteiler auf, der die Aufgabe hat, die in der Leitung vorherrschende Spannung für den elektrischen Antrieb zu vermindern, in der Weise, dass ein Messvorgang über elektronische Schaltkreise möglich wird.

Das obere Teil des Isolierkörpers 3 nimmt einen Stromteiler 2 auf, der sowohl Wechselstrom als auch Gleichstrom messen kann. Der Isolierkörper 3 weist in manchen Fällen, sofern dies erwünscht ist, ein Antennensystem 5 auf und eine Vorrichtung 6 für das Empfangen oder das Übertragen von Signalen GPS, GSM GPRS.

Der Messeingang für die Spannung liegt zwischen Punkt 12 und Punkt 13 (Masse des Fahrzeuges), während der Strom den Sensor 2 durchfließt und dabei in Punkt 12 einläuft und in Punkt 14 ausläuft.

Ein elektronischer Schaltkreis 7, der am oberen Teil des Isolierkörpers 3 angeordnet ist, führt die Messung der Spannung an den Enden des Widerstandes 15 durch, d.h. die getrennte Spannung, die bei Anlegen der Leitungsspannung an den Teiler, bestehend aus Widerstand 4 und Widerstand 15, ansteht.

Die Messung erfolgt über einen Analog-/Digitalwandler, der die Aufgabe hat, den Spannungswert in eine echte Zahl zu verwandeln, um diese über bekannte Maßnahmen über die Leitung aus optischen Faser zu übertragen.

Ein zweiter Analog-/Digitalwandler übernimmt das Messsignal des Stromsensors 2 und verwandelt dieses Signal in eine echte Zahl, um den erhaltenen Wert über ein Kabel, bestehend aus optischen Fasern, weiterleiten zu können.

Unter Einsatz bekannter Techniken besteht die Möglichkeit, sowohl den Wert für die Spannung als auch den Wert für die Stromstärke über eine einzige Leitung, bestehend aus optischen Fasern, weiterzuleiten, oder, sofern die Einrichtung dies vorsieht, über zwei Leitungen, bestehend aus optischen Fasern.

Der elektronische Schaltkreis 7 ermöglicht es ferner, über die Übertragungsvorrichtung 6 zu empfangen bzw. zu übertragen, wobei entsprechende Signale über Antennen 5 zu empfangen bzw. zu übertragen sind.

Alle Signale werden in beiden Richtungen (empfangene Signale oder zu übertragende Signale) unter Zuhilfenahme der Leitung 9, bestehend aus optischen Fasern, an den Schaltkreis 10 übertragen, der in Niedrigspannung arbeitet und am Fuß des Isolierkörpers vorgesehen ist.

Zur Gruppe, bestehend aus optischen Fasern 9, gehören auch die optischen Fasern, welche Spannungswerte und Werte für die Stromstärke übertragen.

Die Einspeisung in den Schaltkreis 7 erfolgt über den Transformator 8, der in dem Isolierkörper 3 eingebettet ist.

Der Transformator wird über den elektronischen Schaltkreis 10 beaufschlagt, und dieser entnimmt Energie von außen über die Kabel, die mit dem Stecker 11 verbunden sind.

Der elektronische Schaltkreis 10 hat die Aufgabe über die optischen Fasern 9 Werte hinsichtlich Spannung und

Stromstärke und digitale Daten für die Übertragung zu empfangen, Daten die über das System 6 über den elektronischen Schaltkreis 7 übertragen werden.

Der elektronische Schaltkreis 10 überträgt ferner jene digitalen Daten, die für die Übertragungsvorrichtung 6 bestimmt sind, hierzu dienen die optischen Fasern 9 sowie der Schaltkreis 7.

Der elektronische Schaltkreis 10, der mit dem Anschluss 11 in Verbindung steht, sofern die Anwendung erwünscht ist, überträgt die Daten, unter Einsatz der Halterung für die elektrischen Kabel, die am Anschluss 11 angeschlossen sind, und empfängt die Daten, die dem elektronischen Schaltkreis 7 zuzuführen sind.

Der elektronische Schaltkreis 10 kann, sofern es erwünscht ist, die empfangenen Signale hinsichtlich Spannung und

Stromstärke aufarbeiten und diese Signale in analoge, elektrische Signale umwandeln, sofern dies notwendig sein sollte, und diese Signale zu verarbeiten, um ableitbare Größen, wie Leistung und Energieinhalt, zu berechnen.

Alle Vorgänge, die durch den elektronischen Schaltkreis 10 verarbeitet werden können, sind nicht als ausschließlich untereinander anzusehen.

Es können Schaltkreise vorgesehen werden, die mehr als eine Funktion durchführen können, gleichzeitig kann z.B. die Umwandlung Digital/Analog der Daten für Spannung und Stromstärke erfolgen, sowie die Berechnung von Leistung und Energie, unter Verwendung der Leitungen, erfolgen, die in 11 vorgesehen sind, die ersten Daten (Spannung und Stromstärke) in analoger Form, und die zweiten Daten in digitaler Form.

Sofern es durch die Anwendung erforderlich werden sollte, kann der elektronische Schaltkreis 10 auch Signale empfangen und übertragen, die für die Übertragungsvorrichtung 6, unter Verwendung optischer Kabel 9 und einem Schaltkreis 7 bestimmt sind.

## Patentansprüche

1. Vorrichtung zum Umschalten und Messen der Spannung und der Stromstärke an Bord eines Schienenfahrzeuges mit elektrischem Antrieb, unter zur Verfügungstellung von einem oder mehreren Übertragungskanälen der Art GPS, GPRS, GSM, die gegenüber der elektrischen Antriebspannung isoliert sind,
**dadurch gekennzeichnet,**
**dass** ein Körper (3) aus Silikon einen Spannungsteiler (4) und einen Sensor (2) für Wechselstrom oder Gleichstrom aufweist, mit einem Transformator (8), der die Stromkreise isoliert, welche an Hochspannung (7) bzw. an Niederspannung angelegt sind, unter Vorsehung von zwei oder mehreren Kabeln (9), bestehend aus optischen Fasern, die zur Übertragung an Schaltkreise, die an Hochspannung (7) oder Niederspannung (10) angelegt sind dienen, und dass ferner vorgesehen ist, dass ein Schaltkreis (7), der an Hochspannung angelegt ist, dazu ausgelegt ist, die Spannung, die zwischen Punkt (12) und Punkt (13) anliegt, und den Strom, der zwischen Punkt (12) und Punkt (14) verläuft, zu messen, unter Vorsehung eines Sensors (2), der in der Lage ist, mit einer Übertragungs- einrichtung (6) zu kommunizieren, des Typs GPS, GSM, GPRS, um Messwerte und Daten über Kabel (9), bestehend aus optischen Fasern, zu übertragen und zu empfangen, dies unter Einsatz eines zweiten Schaltkreises (10), der an Masse (13) anliegt, und dazu dient, die übertragenen Messungen in digitaler Form und mit den Einrichtungen an Bord des Schienenfahrzeuges über Verbindungen (11), die an der Außenseite des Gerätes angeordnet sind, durchzuführen.

2. Vorrichtung zum Messen der Spannung sowie des Stromes an Bord eines Schienenfahrzeuges mit elektrischem Antrieb, nach Patentanspruch 1, **dadurch gekennzeichnet, dass** der aus Silikon bestehende Körper (3) die Form eines elektrischen Isolators aufweist, der einen Sensor für elektrischen Strom aufnimmt, und sowohl Gleichstrom als auch Wechselstrom messen kann.

3. Vorrichtung zum Messen der Spannung sowie des Stromes an Bord eines Schienenfahrzeuges mit elektrischem Antrieb, nach Patentanspruch 1, **dadurch gekennzeichnet, dass** im oberen Teil des aus Silikon bestehenden Körpers (3) eine Übertragungsvorrichtung (6) eingebaut ist und elektrisch angeschlossen werden kann, die geeignet ist, GPS-Signale über Antennen (5) zu empfangen und über Kanäle GSM und GPRS Signale zu übertragen und Signale zu empfangen.

4. Vorrichtung zum Messen der Spannung sowie des Stromes an Bord eines Schienenfahrzeuges mit elektrischem Antrieb, nach Patentanspruch 1, **dadurch gekennzeichnet, dass** die Messung der Spannung sowie der Stromstärke über den elektronischen Schaltkreis (7) erfolgt, der elektrisch mit der Hochspannung der Antriebsleitung verbunden ist.

5. Vorrichtung zum Messen der Spannung sowie des Stromes an Bord eines Schienenfahrzeuges mit elektrischem Antrieb, nach Patentanspruch 1, **dadurch gekennzeichnet, dass** die beiden elektronischen Schaltkreise (7) und (10) untereinander über einen Isoliertransformator (8) und über Leitungen, bestehend aus optischen Fasern (9), verbunden sind, wobei der erste Schaltkreis (7), für die Messung sowie die Übertragung zur Vorrichtung (6) dient, und der zweite Schaltkreis (10) dazu bestimmt ist, die vom Schaltkreis (7) in geeigneter Form empfangenen Messungen für die Verwendung in den Vorrichtungen an Bord des Schienenfahrzeuges umzuwandeln.
